# EUROPÄISCHE PATENTSCHRIFT

(11) **EP 1 535 335 B1**
(45) Veröffentlichungstag und Bekanntmachung des Hinweises auf die Patenterteilung: **09.07.2008**
(21) Anmeldenummer: 03793746.3
(22) Anmeldetag: 21.08.2003
(51) Int. Cl.: H01L 27/115, H01L 21/8246, H01L 29/792, H01L 21/28, H01L 21/336

(54) **HALBLEITERSPEICHER MIT VERTIKALEN SPEICHERTRANSISTOREN IN EINER ZELLENFELDANORDNUNG MIT 1 - 2F² - ZELLEN**
SEMICONDUCTOR MEMORY WITH VERTICAL MEMORY TRANSISTORS IN A CELL FIELD ARRANGEMENT WITH 1 - 2F² CELLS
MEMOIRE A SEMICONDUCTEURS POURVUE DE TRANSISTORS DE MEMOIRE VERTICAUX DANS UN ENSEMBLE CHAMP DE CELLULES 1 - 2F²

(30) Priorität: 05.09.2002 DE 10241173
(43) Veröffentlichungstag der Anmeldung: 01.06.2005
(73) Patentinhaber: Infineon Technologies AG, 81669 München (DE)
(72) Erfinder: HOFMANN, Franz, 80995 München (DE); LANDGRAF, Erhard, 81543 München (DE); LUYKEN, Richard, Johannes, 81825 München (DE); SCHULZ, Thomas, 3001 Heverlee (BE); SPECHT, Michael, 80799 München (DE)
(74) Vertreter: Müller-Boré & Partner Patentanwälte
(86) Internationale Anmeldenummer: PCT/EP2003/009296
(87) Internationale Veröffentlichungsnummer: WO 2004/023557

(56) Entgegenhaltungen:
- WO-A-02/15278
- US-A- 4 774 556
- US-A- 5 869 369
- US-B1- 6 285 596

## Beschreibung

Die Erfindung betrifft einen Halbleiterspeicher mit einer Vielzahl von Speicherzellen gemäß Anspruch 1.

Nichtflüchtige Halbleiterspeicherelemente sind in einer Vielzahl unterschiedlicher Ausführungsformen bekannt. Je nach Anwendung kommen beispielsweise PROM, EPROM, EEPROM, Flash-Speicher sowie SONOS-Speicher zum Einsatz. Diese unterscheiden sich insbesondere in Löschoption, Programmierbarkeit und Programmierzeit, Haltezeit, Speicherdichte sowie ihren Herstellungskosten. Für eine Vielzahl von Anwendungen hat ein niedriger Herstellungspreis verbunden mit einem Minimum an weiteren Optionen die höchste Priorität. Es wäre insbesondere wünschenswert, ein besonders preiswertes Speicherelement zur Verfügung zu haben, welches zumindest einmal elektrisch bei möglichst niedrigen Spannungen von weniger als 10 V programmierbar ist, eine Haltezeit im Bereich von 10 Jahren aufweist und kompatibel mit heutiger CMOS-Technologie bei geringstmöglichen Änderungen ist.

Ein bekannter nichtflüchtiger Halbleiterspeicher, welcher mit heutiger CMOS-Technologie kompatibel ist, ist beispielsweise in der europäischen Patentanmeldung mit der Anmeldenummer EP 02 004 568.8 beschrieben. Hierbei weist jede Speicherzelle des Halbleiterspeichers einen planaren Transistor (planarer MOSFET) auf, bei welchem eine sogenannte Trapping-Schicht in einer Aussparung des (Steuer-)Gateabschnitts vorgesehen ist. Heiße Elektronen, welche durch geeignete Potentialverhältnisse an den Transistoranschlüssen in dem Transistorkanal erzeugbar sind, können die dünne Gateoxidschicht überwinden und von dieser Trapping-Schicht eingefangen werden. Die Anwesenheit der in der Trapping-Schicht eingefangenen Elektronen bewirkt eine Kennlinienverschiebung des Transistors, was sich insbesondere in einer unterschiedlichen Einsatzspannung (Threshold-Spannung)äußert. Der Unterschied der Threshold-Spannung kann in bekannter Weise zum Schreiben eines "bits" ausgenutzt werden, da er mittels eines Leseschritts ermittelt werden kann.

Die US 6 285 596 B1 offenbart einen nichtflüchtigen Halbleiterspeicher bestehend aus einzelnen Speicherzellen. In jeder dieser Zellen kann eine Speicherschicht, die auf einem Kanal zwischen zwei Kontakten (Source und Drain) angeordnet ist, Ladungen speichern. Diese Speicherschicht besteht aus mindestens drei gegeneinander isolierten dielektrischen Ladungstrappingschichten, so daß je nach Ladungszustand der einzelnen Trappingschichten mindestens vier Speicherzustände angenommen werden können. Der Kanal beinhaltet dabei eine vertikale Komponente und dient zum Auslesen des Ladungszustandes in der Speicherschicht.

Die WO 02/15278 A2 offenbart einen Speichertransistor mit vertikalem Kanalstrom und mehreren unabhängigen Gate-Flächen. Die Gates sind vom Kanal jeweils durch zwei Isolationsschichten und eine dazwischen angeordnete Ladungstrappingschicht getrennt und können einzeln angesteuert werden. Insbesondere ist eine säulenförmige Anordnung mit rechteckigem Querschnitt vorgeschlagen, an deren Seitenflächen jeweils eine Ladungstrappingschicht und darüber ein Gate angeordnet sein können. Der Kanalstrom fließt dabei an den seitlichen Oberflächen der säulenförmigen Anordnung zwischen zwei Kontakten (Source und Drain) am unteren bzw. oberen Ende der Säule und wird über den Ladungszustand aller an der Säule angeordneten Ladungstrappingschichten, die als Ladungsspeicher fungieren, bestimmt. Dabei nutzen die Kanalbereiche unter den einzelnen Gates innerhalb einer Säule einen gemeinsamen Source- und einen gemeinsamen Drainkontakt.

Nachteilig ist jedoch an diesem bekannten Speicherkonzept die nur eingeschränkt mögliche Skalierbarkeit der Speichertransistoren, so daß hochdichte - und damit besonders kostengünstig herstellbare - Halbleiterspeicher mit derartigen Speichertransistoren nicht herstellbar sind. Hauptanwendungsgebiet dieser herkömmlichen Speichertransistoren sind folglich lediglich Logikschaltungen bzw. "System on chip"-Schaltungen (SOC-Schaltungen) mit geringer Speicherdichte.

Ein weiterer Speichertransistor, welcher den eingangs genannten Anforderungen noch am ehesten entspricht, ist ein nach dem SONOS-Konzept hergestellter Transistor, wie er von Eitan et al. in "NROM: A novel localised trapping, 2-bit nonvolatile Memory Cell", IEEE Electron Device Letters, Vol. 21, No. 11, November 2000, Seiten 543-545 beschrieben ist. Jedoch weist auch dieses Speicherkonzept hinsichtlich seiner Skalierbarkeit Nachteile auf, so daß eine hochdichte bzw.-kompakte Anordnung von Speichertransistoren mit kleinsten Abmessungen schwierig ist. Die kleinsten erreichbaren Zellenflächen bei derartigen NROMs liegen bei typischerweise 2F² im Idealfall, wobei F die kleinste im Strukturbreite des Halbleiterspeichers darstellt. In der Praxis sind aufgrund technologiebedingter Sicherheitsabstände lediglich 3F² erreichbar.

Angesichts der obigen Nachteile ist es eine Aufgabe der Erfindung, einen Halbleiterspeicher mit einer Vielzahl von Speicherzellen anzugeben, welcher bei einfacher Herstellung eine hochdichte Zellenanordnung gestattet.

Diese Aufgabe wird durch einen Halbleiterspeicher gemäß Anspruch 1 gelöst. Bevorzugte Ausführungsformen sind Gegenstand der abhängigen Ansprüche.

Gemäß der Erfindung wird ein Halbleiterspeicher mit einer Vielzahl von Speicherzellen vorgeschlagen, wobei jeder der Speicherzellen umfaßt:
- eine auf einem Substrat angeordnete, deren Halbleiteroberfläche zumindest eine Stufe zwischen einem tieferen und einem in Substratnormalenrichtung höheren Halbleiterbereich aufweist;
- vier in dem tieferen Halbleiterbereich ausgebildete leitfähig dotierte tiefere Kontaktbereiche und einen in dem höheren Halbleiterbereich ausgebildeten leitfähig dotierten höheren Kontaktbereich, wobei jeder der tieferen Kontaktbereiche mit genau einem angrenzendem tieferen Kontakt und jeder der höheren Kontaktbereiche mit genau einem angrenzendem höheren Kontakt elektrisch verbunden ist;
- vier Kanalbereiche, welche sich in der Halbleiterschicht zwischen dem tieferen und dem höheren Kontaktbereich erstrecken;
- zumindest eine zum Einfangen und Abgeben von Ladungsträgern ausgelegte elektrisch isolierende Trapping-Schicht, welche an einer an die Kanalbereiche angrenzenden Gateoxidschicht angeordnet ist; und
- zumindest eine Gateelektrode zur Steuerung der elektrischen Leitfähigkeit des Kanalbereichs, wobei zwischen der Gateelektrode und der Trapping-Schicht eine Steueroxidschicht angeordnet ist.

Bei dem erfindungsgemäßen Halbleiterspeicher kommt für die Speichertransistoren ein sogenanntes vertikales Transistorkonzept zum Einsatz. Hierbei ist einer der Kontaktbereiche (d.h. der Speichertransistorkontakte) in einem tieferen Halbleiterbereich und der zweite Kontaktbereich (der zweite Speichertransistorkontakt) in einem höheren Halbleiterbereich angeordnet. Beispielsweise befindet sich ein Kontaktbereich des Speichertransistors in einem tieferen Halbleiterbereich, welcher durch einen Mesaätzschritt gegenüber einem höheren Kontaktbereich abgetragen wurde.

Der höhere Kontaktbereich ist in dem höheren Halbleiterbereich angeordnet, wobei zwischen den beiden Halbleiterbereichen eine Stufe vorgesehen ist. Der Abstand zwischen einer tieferen Bereichsoberfläche des tieferen Halbleiterbereichs zu einer Substratebene ist somit geringer als der entsprechende Abstand einer höheren Bereichsoberfläche des höheren Halbleiterbereichs. Mit anderen Worten ist in Normalenrichtung des Halbleitersubstrats die Bereichsoberfläche des höheren Halbleiterbereichs weiter von dem Substrat als die Bereichsoberfläche des tieferen Halbleiterbereichs entfernt. Dies hat zur Folge, daß der sich zwischen dem tieferen und höheren Kontaktbereich erstreckende Transistorkanal nicht lediglich parallel zur Substratebene verläuft, sondern eine vertikale Komponente aufweist.

Entlang der Oberfläche des Kanalbereichs ist eine dünne Gateoxidschicht in üblicher Weise angeordnet. An einen Teil der Gateoxidschicht grenzt eine sogenannte Trapping-Schicht an, welche zum Einfangen und Abgeben von Ladungsträgern ausgelegt ist. Die Trapping-Schicht weist eine große Anzahl von Störstellen bzw. "Trap-Zuständen" auf, in welchen eingefangene Ladungsträger (Elektronen oder Löcher) dauerhaft gespeichert werden können. Die Trapping-Schicht ist auf ihren nicht an die Gateoxidschicht angrenzenden Oberflächen von einer Steueroxidschicht umgeben, so daß sie vollständig von Oxidschichten umhüllt ist. Vorzugsweise besteht die Trapping-Schicht aus einer Nitridschicht, insbesondere einer Siliziumnitridschicht, so daß sich im Schnitt durch den Speichertransistor eine Oxid-Nitrid-Oxid-Schichtabfolge ergibt (sogenannter ONO-Stack).

An der Steueroxidschicht ist eine (Steuer-)Gateelektrode angeordnet, durch welche in bekannter Weise die elektrische Leitfähigkeit des Transistorkanals über den Feldeffekt gesteuert werden kann. Vorzugsweise grenzt die Gateelektrode bereichsweise auch an die an dem Kanalbereich angeordnete Gateoxidschicht an, so daß die Leitfähigkeit eines Abschnitts des Transistorkanals direkt durch die Gateelektrode steuerbar ist.

Eine zwischen dem tieferen und dem höheren Kontaktbereich des Speichertransistors angelegte Potentialdifferenz bewirkt vorzugsweise einen Feldlinienverlauf zwischen den Kontaktbereichen, bei welchem elektrische Feldlinien von dem Transistorkanal durch die Gateoxidschicht in die Trapping-Schicht verlaufen. Im Unterschied zu planaren Speichertransistoren, wie sie beispielsweise aus der eingangs genannten EP 02 004 568.8 bekannt sind, wird der Injektionsprozeß von heißen Kanalelektronen (channel hot electrons (CHE)) bereits durch die Orientierung des zwischen den Kontaktbereichen aufgebauten elektrischen Feldes unterstützt. Dies ermöglicht bereits bei geringen Programmierspannungen effizient Elektronen aus dem Speichertransistorkanal in die Trapping-Schicht zu injizieren, wodurch entweder die notwendige Programmierspannung oder die Programmierzeit bzw. die notwendige Programmierleistung (P=U • I • Δt) reduziert werden kann. Ferner trägt die zwischen dem tieferen und dem höheren Kontaktbereich vorgesehene Stufe (Mesakante) zu einer gesteigerten Programmiereffizienz aufgrund einer gesteigerten Injektionsausbeute heißer Elektronen bei. Die Trapping-Schicht ist vorzugsweise nur an einem verhältnismäßig kleinen Bereich der Gateoxidschicht angeordnet. An den übrigen Bereichen der Gateoxidschicht grenzt vorzugsweise unmittelbar die Gateelekrode an.

Jedem höheren Kontaktbereich, welcher in dem höheren Halbleiterbereich angeordnet ist, sind vier tiefere Kontaktbereiche zugeordnet, so daß sich zwischen jedem der tieferen Kontaktbereiche und dem höheren Kontaktbereich ein Transistorkanal einer vertikalen Speichertransistors bildet. Beispielsweise handelt es sich bei dem höheren Kontaktbereich um einen gemeinsamen Source-Kontakt und bei den vier zugeordneten tieferen Kontaktbereichen um Drainkontakte der vier Speichertransistoren. In gleicher Weise sind jedem der tieferen Kontaktbereiche vier benachbarte höhere Kontaktbereiche zugeordnet, zwischen welchen Kanalbereiche verlaufen.

Die auf den Aufbau des Speicherzellenfeld des erfindungsgemäßen Halbleiterspeichers gerichtete Beschreibung bezieht sich im wesentlichen auf die Zellenfeldanordnung im Inneren des Zellenfeldes. In Randbereichen des Zellenfeldes kann es zusätzliche Speicherzellen geben, bei welchen höhere Kontaktbereiche nicht von vier tieferen Kontaktbereichen umgeben sind. Beispielsweise kann am Rand des Speicherzellenfeldes ein höherer Kontaktbereich vorgesehen sein, welchen lediglich drei oder zwei tiefere Kontaktbereiche zugeordnet sind.

Der erfindungsgemäße Halbleiterspeicher ermöglicht eine hohe Packungsdichte, da aufgrund des vertikalen Transistorkonzepts die Speicherzellenfläche unabhängig von der Kanallänge des Transistors skaliert werden kann. Im Gegensatz zu planaren Speicherkonzepten (beispielsweise NROMs) ist der erfindungsgemäße Speichertransistor wesentlich einfacher zu skalieren und zeigt geringere Kurzkanaleffekte. Die Anordnung des erfindungsgemäßen Zellenfeldes ermöglicht insbesondere hochdichte Packungsdichten mit 1 bis 2F² Zellen.

Weitere Vorteile des erfindungsgemäßen Halbleiterspeichers gegenüber herkömmlichen Speicherbauelementen liegen in den vergleichsweise niedrigen Herstellungskosten und der Einfachheit des Herstellungsprozesses. Gegenüber einem Standard CMOS-Herstellungsprozeß ist lediglich eine zusätzliche Maske für die Mesa- bzw. Stufenätzung notwendig. Gegenüber klassischen Floating-Gate Speicherbauelementen, welche ein elektrisch leitfähiges Floating-Gate aus typischerweise Polysilizium enthalten, ist lediglich eine einzige Polysiliziumabscheidung notwendig, wenn die Gateelektrode aus hochdotiertem Polysilizium bestehen soll.

Vorzugsweise sind die tieferen und die höheren Kontakte in einem regelmäßigen matrixartigen Zellenfeld mit Zeilen und Spalten angeordnet und entlang jeder der Zeilen und Spalten sind die tieferen und die höheren Kontakte alternierend angeordnet. Die tieferen und die höheren Kontakte sind somit in einem vorzugsweise quadratischen Raster angeordnet, welches durch Zeilen und Spalten gebildet wird. Entlang jeder der Zeilen und jeder der Spalten sind die tieferen und die höheren Kontakte alternierend bzw. abwechselnd angeordnet, wobei jeweils zwischen zwei benachbarten Kontakten ein Kanalbereich vorgesehen ist.

Vorzugsweise verlaufen die Zeile Längsrichtung der Zeilen und die Spalten Längsrichtung der Spalten senkrecht zueinander. Zeilen und Spalten kreuzen sich somit im Zellenfeld in rechten Winkeln. Vorzugsweise entspricht die Abmessung der tieferen und der höheren Kontakte genau 1F², wobei F die minimale Strukturgröße des Halbleiterspeichers darstellt. Vorzugsweise sind benachbarte Kontakte in lateraler Richtung parallel zur Substratebene um den Abstand F voneinander beabstandet, um eine möglichst große Zellenfelddichte zu erreichen.

Vorzugsweise weist jeder der höheren Halbleiterbereiche eine Vielzahl der höheren Kontaktbereiche auf. Somit sind in jedem der höheren Halbleiterbereiche, d.h. "auf der Mesa", mehrere höhere Kontaktbereiche angeordnet. Zwischen diesen höheren Kontaktbereichen ist keine Stufe bzw. keine Mesaflanke vorhanden. Gleichermaßen sind vorzugsweise in dem tieferen Halbleiterbereich eine Vielzahl von tieferen Kontaktbereichen vorgesehen, zwischen welchen ebenfalls keine Stufe bzw. keine Mesaflanke vorgesehen ist.

Vorzugsweise erstrecken sich die höheren Halbleiterbereiche in schräg zu der Zeilen- und der Spaltenlängsrichtung verlaufenden Mesalängsrichtungen. Der höhere Halbleiterbereich, d.h. der erhöhte Mesabereich, weist demgemäß eine Längsachse auf, welche schräg zu der Zeilenlängsrichtung und der Spaltenlängsrichtung verläuft. Besonders bevorzugt ist eine Anordnung, bei welcher die Zeilenlängsrichtung senkrecht zu der Spaltenlängsrichtung verläuft und die Mesalängsrichtungen 45° gegenüber der Zeilenlängsrichtung und 45° gegenüber der Spaltenlängsrichtung verdreht sind. Somit verläuft die Mesalängsrichtung in "Diagonalenrichtung" über das Speicherzellenfeld. Bevorzugt verläuft der höhere Halbleiterbereich durch das gesamte Zellenfeld und ist von zwei benachbarten tieferen Halbleiterbereichen umgeben.

Vorzugsweise trennt jede der höheren Halbleiterbereiche zwei der tieferen Halbleiterbereiche voneinander, welche an gegenüberliegenden Stufenseitenflächen des höheren Halbleiterbereichs angrenzen. Somit grenzen an jeden langgestreckten höheren Halbleiterbereich zwei ebenfalls langgestreckte tiefere Halbleiterbereiche an, wobei die tieferen und der höhere Halbleiterbereich jeweils eine Vielzahl der Kontaktbereiche enthalten.

Vorzugsweise ist jedem der höheren Halbleiterbereiche eine gemeinsame Gateelektrode zugeordnet. Die Gateelektrode erstreckt sich entlang den gegenüberliegenden Stufenseitenflächen des höheren Halbleiterbereichs vorzugsweise in Form eines Polysiliziumspacers mit der eingangs genannten Anordnung. In diesem Fall ist jedem der vier Kanalbereiche, welche einem der höheren Kontaktbereiche zugeordnet sind, die gleiche gemeinsame Gateelektrode zugeordnet. Wenn in dem höheren Halbleiterbereich eine Vielzahl höherer Kontaktbereiche vorgesehen sind, so werden sämtliche Kanalbereiche, welche diesen höheren Kontaktbereichen zugeordnet sind, durch eine einzige gemeinsame Gateelektrode versorgt.

Alternativ sind jedem der höheren Halbleiterbereiche zwei elektrisch voneinander isolierte Gateelektroden zugeordnet. Vorzugsweise erstreckt sich die Gateelektrode bzw. erstrecken sich die Gateelektroden im wesentlichen entlang der Mesalängsrichtung des höheren Halbleiterbereichs angrenzend an dessen Stufenseitenflächen. Die Gateelektroden sind bevorzugt spacerartig mittels eines Spacerätzschrittes derart ausgebildet, daß sie angrenzend an die Stufenseitenflächen des höheren Halbleiterbereichs verlaufen. Wenn zwei Gateelektroden für einen höheren Halbleiterbereich vorgesehen sind, kann sich eine erste Gateelektrode entlang einer ersten Längsseite des langgestreckten höheren Halbleiterbereichs erstrecken und eine zweite Gateelektrode sich an der gegenüberliegenden Längsseite des höheren Halbleiterbereichs erstrecken. Die Gateelektroden, welche den höheren Halbleiterbereich ansonsten vollständig spacerartig umgeben können, sind in diesem Fall an geeigneten Stellen unterbrochen, so daß die erste und die zweite Gateelektrode unabhängig voneinander kontaktierbar sind.

Vorzugsweise ist eine Vielzahl von senkrecht zu den Mesalängsrichtungen verlaufenden Bitleitungen vorgesehen, welche jeweils mit einer Vielzahl der höheren Kontaktbereiche elektrisch verbunden sind. Die Bitleitungen können beispielsweise in einer ersten Metallebene geführt werden. Sie schneiden die langgestreckten höheren Halbleiterbereiche im wesentlichen rechtwinklig und verlaufen schräg zu der Spalten- und der Zeilenlängsrichtung.

Es kann vorteilhaft sein, die langgestreckten höheren Halbleiterbereiche sowie die Bitleitungen nicht geradlinig über das gesamte Zellenfeld zu führen. Stattdessen kann beispielsweise eine sägezahnförmige Führung der Bitleitungen und der langgestreckten höheren Halbleiterbereiche vorgesehen werden, welche zu einer geringeren Längenvariation der Bitleitungslängen sowie der Längen der höheren Halbleiterbereiche führen wird. Dies hat hinsichtlich der anzuschließenden Auswerte- bzw. Programmierelektronik wesentliche Vorteile.

Vorzugsweise verlaufen die Bereichsoberflächen des tieferen und des höheren Halbleiterbereichs im wesentlichen parallel zu der Substratebene. Bei dem Substrat handelt es sich vorzugsweise um ein einkristallines Siliziumsubstrat und bei der Halbleiterschicht um eine einkristalline Siliziumschicht.

Vorzugsweise bildet die Bereichsoberfläche jedes höheren Halbleiterbereichs eine Oberfläche des höheren Kontaktbereichs. Der höhere Halbleiterbereich, d.h. die Mesa, weist somit vorzugsweise entlang seiner gesamten, parallel zu der Substratebene verlaufenden Bereichsoberfläche eine leitfähige Dotierung auf, so daß die an die höhere Bereichsoberfläche angrenzende Schicht den höheren Kontaktbereich bildet.

Vorzugsweise sind die Bereichsoberflächen des tieferen und des höheren Halbleiterbereichs durch eine Stufenseitenfläche der Stufe (der Mesakante) verbunden, welche im wesentlichen senkrecht zu der Substratebene verläuft. Der höhere Halbleiterbereich ist somit durch eine senkrechte Mesakante bzw. -flanke von dem tieferen Halbleiterbereich getrennt.

Vorzugsweise ist die Trapping-Schicht durch die Gateoxidschicht von der Stufenseitenfläche und der Bereichsoberfläche des tieferen Halbleiterbereichs beabstandet. Die Trapping-Schicht ist somit vorzugsweise in dem Eck- bzw. Kantenbereich der Mesa angeordnet. Die Trapping-Schicht grenzt sowohl an die Gateoxidschicht, welche an der Stufenseitenfläche angeordnet ist, als auch an die Gateoxidschicht, welche an der Bereichsoberfläche des tieferen Halbleiterbereichs angeordnet ist, an. Eine derartige Trappingschicht kann in einfacher selbstjustierender Weise (ohne Fotoschritt) mittels einer sogenannten Spacerätzung hergestellt werden. Die Trapping-Schicht ist ähnlich einem aus der CMOS-Technologie bekannten Spacer an der Stufenseitenfläche angeordnet.

Gemäß einer weiteren bevorzugten Ausführungsform sind die Bereichsoberflächen des tieferen und des höheren Halbleiterbereichs durch eine tiefere Stufenseitenfläche, eine höhere Stufenseitenfläche und eine sich zwischen den Stufenseitenflächen erstreckende Zwischenfläche miteinander verbunden. Bei dieser Ausführungsform ist eine Doppelstufe bzw. eine Doppelmesa vorgesehen. Die Stufenseitenflächen verlaufen vorzugsweise im wesentlichen senkrecht zu der Substratebene. Die beiden Stufenseitenflächen grenzen an die tiefere bzw. die höhere Bereichsoberfläche an und werden durch eine vorzugsweise parallel zu der Sustratebene verlaufende Zwischenfläche verbunden.

Vorzugsweise ist jedem der Kanalbereiche eine tiefere und eine höhere der Trapping-Schichten zugeordnet, wobei die tiefere Trapping-Schicht durch die Gateoxidschicht von der tieferen Stufenseitenfläche und der Bereichsoberfläche des tieferen Halbleiterbereichs und die höhere Trapping-Schicht durch die Gateoxidschicht von der höheren Stufenseitenfläche und der Zwischenfläche beabstandet ist. Mit einem derartigen Speichertransistor können zwei "Bit" gespeichert werden, wenn die von NROMs bekannte Programmier- und Lesetechnik verwendet wird. Hierbei müssen in bekannter Weise zum Lesen die Kontaktbereiche gegenüber dem Programmiervorgang vertauscht werden. In diesem Zusammenhang wird auf die eingangs genannte Veröffentlichung von EITAN et al. verwiesen sowie auf die internationale Patentanmeldung WO 99/07000 (PCT/IL98/00363). Auf diese Veröffentlichung sowie auf die genannte internationale Patentanmeldung wird hinsichtlich des Lese- und Programmierverfahrens in vollem Umfang Bezug genommen, so daß diesbezüglich die genannten Veröffentlichungen integrale Bestandteile der Gesamtoffenbarung der vorliegenden Anmeldung sind.

Bei der bevorzugten Ausführungform sind jedem der Kanalbereiche zwei verschiedene Trapping-Schichten, welche räumlich voneinander getrennt sind, zugeordnet. Die tiefere Trapping-Schicht ist vorzugsweise in dem Kanten- bzw. Eckbereich angrenzend an die tiefere Bereichsoberfläche und die tiefere Stufenseitenfläche angeordnet. Die tiefere Trapping-Schicht ist durch die Gateoxidschicht von dem Kanalbereich beabstandet. Die höhere Trapping-Schicht ist vorzugsweise in dem Kanten- bzw. Eckbereich angrenzend an die Zwischenfläche und die höhere Stufenseitenwand angeordnet, wobei sie wiederum durch die Gateoxidschicht vom Kanalbereich beabstandet ist. Die Gateelektrode erstreckt sich vorzugsweise über die beiden Trapping-Schichten, von denen sie durch die Steueroxidschicht getrennt ist. Zwischen der tieferen Trapping-Schicht und der höheren Trapping-Schicht grenzt die Gateelektrode bereichsweise an die Gateoxidschicht an, so daß in diesem Bereich die elektrische Leitfähigkeit des Transistorkanals unmittelbar steuerbar ist.

Vorzugsweise erstreckt sich der tiefere Kontaktbereich bis an eine Stufenseitenfläche der Stufe (d.h. bis an eine Flanke der Mesa). Simulationen haben gezeigt, daß ein besonders effizienter Injektionsmechanismus von heißen Kanalelektronen in die Trapping-Schicht erzielt werden kann, wenn der tiefere Kontaktbereich sich bis an den Kanten- bzw. Eckbereich der Mesa, d.h. bis an die Stufenseitenfläche erstreckt. In gleicher Weise ist es ferner vorteilhaft, den höheren Kontaktbereich derart auszubilden, daß er sich bis zu der tieferen Bereichsoberfläche (bzw. zu einer eventuell vorgesehenen Zwischenfläche) erstreckt. In diesem Fall muß ein Abstand zwischen dem tieferen Kontaktbereich und der Stufenseitenfläche vorgesehen sein.

Vorzugsweise besteht die Trappingschicht aus Siliziumnitrid. In diesem Fall bildet die Trappingschicht mit den sie umgebenden Siliziumdioxidschichten einen sogenannten ONO-Stack. Gleichermaßen können jedoch auch andere Dielektrika mit großen Dielektrizitätskonstanten ("high-k Dielektrika") zum Einsatz kommen. Geeignet ist ferner sogenanntes "silicon rich oxide" sowie undotiertes Polysilizium zur Ausbildung der Trapping-Schicht.

Die Erfindung wird im folgenden anhand begleitender Zeichnungen bevorzugter Ausführungsformen beispielhaft beschrieben. Es zeigt:
- Fig. 1(a): eine schematische Schnittansicht durch eine Speicherzelle einer ersten bevorzugten Ausführungsform eines erfindungsgemäßen Halbleiterspeichers, wobei die Schnittebene senkrecht zu der Substratebene verläuft;
- Fig. 1(b): eine schematische Schnittansicht einer Speicherzelle einer zweiten bevorzugten Ausführungsform mit einer Doppelstufe;
- Fig. 1(c): eine schematische Schnittansicht einer Speicherzelle gemäß einer dritten bevorzugten Ausführungsform mit vorgezogenem tieferen Kontaktbereich;
- Fig. 1(d): eine schematische Schnittansicht einer Speicherzelle gemäß einer dritten bevorzugten Ausführungsform mit durchgängigem ONO-Schichtstapel;
- Fig.2(a): eine schematische Aufsicht auf eine Zellenfeldanordnung einer bevorzugten Ausführungsform des erfindungsgemäßen Halbleiterspeichers, wobei die Zellenfeldanordnung anhand einer Überlagerung wesentlicher Prozeßmasken veranschaulicht ist;
- Fig.2(b): eine schematische Schnittansicht entlang der Linie A-A von Fig. 2(a); und
- Fig. 3: eine schematische Aufsicht der in Fig. 2(a) dargestellten Ausführungsform mit der Darstellung der für die Metall 1, Metall 2 und Metall 3-Ebenen verwendeten Masken.

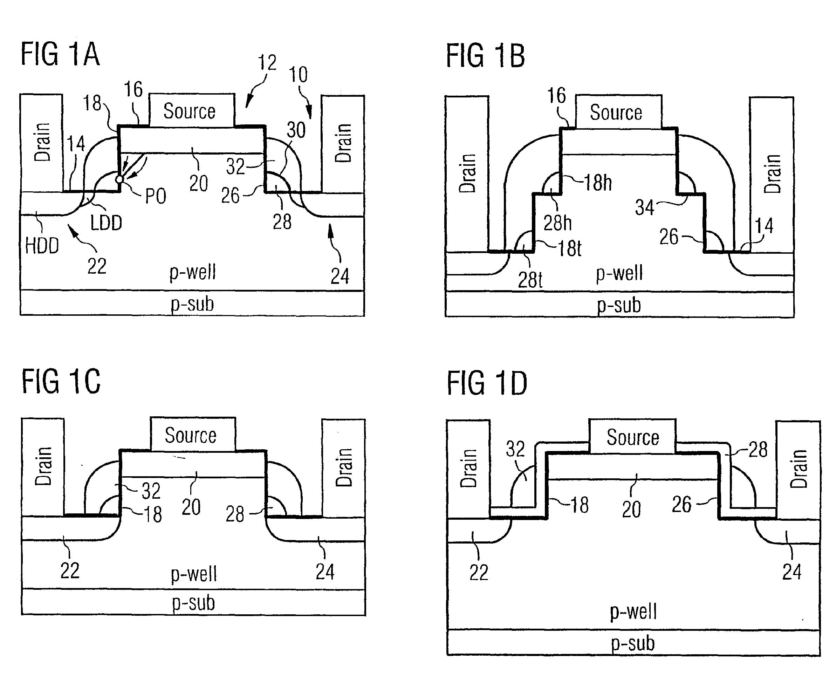

In **Fig. 1(a)** ist eine erste bevorzugte Ausführungsform eines Speichertransistors dargestellt, welcher sich in besonderem Maße für einen erfindungsgemäßen Halbleiterspeicher eignet, in einer schematischen Schnittansicht dargestellt. Die Schnittebene verläuft durch den Speichertransistor senkrecht zu der Substratebene des Halbleitersubstrats p-sub. Auf dem beispielsweise p-dotierten Halbleitersubstrat p-sub ist eine einkristalline Halbleiterschicht p-well angeordnet, welche beispielsweise leicht p-dotiert ist. Die Halbleiterschicht p-well ist in einen tieferen Halbleiterbereich 10 und einen höheren Halbleiterbereich 12 beispielsweise durch einen Mesaätzschritt strukturiert. Der tiefere Halbleiterbereich 10 weist eine tiefere Bereichsoberfläche 14 auf, welche im wesentlichen parallel zu der Substratebene des Substrats p-sub verläuft. Der höhere Halbleiterbereich 12 weist eine höhere Bereichsoberfläche 16 auf, welche ebenfalls parallel zu der Substratebene angeordnet ist. Bei der in Fig. 1(a) gezeigten Ausführungsform ist die höhere Bereichsoberfläche 16 des höheren Halbleiterbereichs 12 über Stufenseitenflächen 18 mit den tieferen Bereichsoberflächen 14 verbunden.

Angrenzend an die höhere Bereichsoberfläche 16 des höheren Halbleiterbereichs 12 ist ein höherer Kontaktbereich 20 gebildet. Der hochdotierte höhere Kontaktbereich 20 stellt beispielsweise den Sourcekontakt SOURCE des Speichertransistors dar. In dem in Fig. 1(a) gezeigten Schnitt sind ferner zwei tiefere Kontaktbereiche 22, 24 dargestellt, welche in dem tieferen Halbleiterbereich 10 ausgebildet sind. Die tieferen Kontaktbereiche 22, 24 stellen beispielsweise zwei der Drainkontakte DRAIN der Speichertransistoren dar. In der in Fig. 1(a) gezeigten Ausführungsform weisen die tieferen Kontaktbereiche 22, 24 einen hochdotierten Bereich HDD (highly doped drain) und einen näher an dem höheren Kontaktbereich angeordneten geringer dotierten Kontaktbereich LDD (lightly doped drain) auf.

Die Kanalbereiche der in Fig. 1(a) dargestellten beiden Speichertransistoren erstrecken sich zwischen den jeweiligen tieferen Kontaktbereichen 22, 24 und dem höheren Kontaktbereich 20 an der Grenzfläche von Gateoxidschichten 26 in der Halbleiterschicht p-well. Der Kanalbereich weist zumindest bereichsweise eine senkrecht zu der Substratebene verlaufende Kanalrichtung auf, so daß es sich bei den Speichertransistoren um vertikale Bauelemente handelt. Die tieferen Kontaktbereiche 22, 24 sowie der höhere Kontaktbereich 20 sind durch schematisch angedeutete Metallkontakte elektrisch kontaktiert. Im Eck- bzw. Kantenbereich der Mesa, d.h. in der zwischen der unteren Bereichsoberfläche 14 und der Stufenseitenfläche 18 gebildeten Kante ist bei jedem der Speichertransistoren eine Trapping-Schicht 28 angeordnet. Die Trapping-Schicht besteht beispielsweise aus Siliziumnitrid, welches durch eine Siliziumdioxidschicht (Gateoxidschicht 26) von dem Kanalbereich beabstandet ist. Die Trapping-Schicht 28 kann in einem selbstjustierenden Prozeß (sogenannte Spacerätzung) ohne zusätzlichen Lithographieschritt gebildet werden.

An der Oberfläche der Trapping-Schicht 28, welche nicht an die Gateoxidschicht 26 angrenzt, ist eine Steueroxidschicht 30 aufgebracht, durch welche die Trapping-Schicht 28 von der Gateelektrode 32 getrennt wird. Die Steueroxidscicht 30, die Trappingschicht 28 und die Gateoxidschicht 26 bilden einen sogenannten ONO-Stack. Eine in Fig. 1(a) nicht näher dargestellte Passivierung schützt die Kontaktbereiche sowie die Gateelektrode und isoliert diese elektrisch voneinander.

Die Gateelektrode 32 ist vorzugsweise aus hochdotiertem Polysilizium gebildet. Die Gateelektrode 32 grenzt an einen Bereich der Gateoxidschicht 26 an, so daß die elektrische Leitfähigkeit des zugeordneten Kanalbereichs unmittelbar gesteuert werden kann. Vorzugsweise beträgt die Kanallänge, deren Leitfähigkeit unmittelbar durch die Gateelektrode 32 steuerbar ist, 20 bis 50 nm. Die Breite des höheren Halbleiterbereichs 12 beträgt vorzugsweise 50 bis 200 nm, wobei der Höhenunterschied in Substratnormalenrichtung zwischen der höheren Bereichsoberfläche 16 und der tieferen Bereichsoberfläche 14 vorzugsweise 50 bis 150 nm beträgt Es sind jedoch auch deutlich größere Kanallängen bzw. Abmessungen von bis zu mehreren µm möglich.

Die Funktionsweise des Speichertransistors der in Fig. 1(a) gezeigten Speicherzelle ist für den zwischen den Kontaktbereichen 22 und 20 gebildeten Transistor veranschaulicht. Durch eine Vorwärtsspannung, welche unter 10 V liegt, wird beispielsweise der tiefere Kontaktbereich 22 gegenüber dem höheren Kontaktbereich 20 positiv vorgespannt. Ferner wird die Gateelektrode 32 gegenüber dem höheren Kontaktbereich 20 positiv vorgespannt. Bei geeigneten Potentialverhältnissen an den Transistorkontakten wird der Speichertransistor in seinen Sättigungsbereich geführt. Bei derartigen Source-Drain-Spannungen, welche größer als die sogenannte Pinch-off-Spannung sind, gibt es längs des Transistorkanals einen sogenannten Pinch-Off-Punkt PO. Die Spannung zwischen dem tieferen Kontaktbereich 22 und dem höheren Kontaktbereich 20 wird vorzugsweise derart eingestellt, daß sich der Pinch-Off-Punkt PO nahe dem höheren Kontaktbereich 20 an einer Stelle des Transistorkanals befindet, welcher der Trapping-Schicht 28 gegenüberliegt. Bei derartigen Potentialverhältnissen an den Transistorkontakten werden insbesondere nahe dem Pinch-Off-Punkt PO sogenannte heiße Elektronen (channel hot electrons (CHE)) erzeugt, welche eine ausreichende Energie aufweisen, um die dünne Gateoxidschicht 26 zu überwinden und in die Trapping-Schicht 28 eingelagert zu werden. Durch die Einlagerung von Elektronen in die Trapping Schicht 28 verschiebt sich die Kennlinie des Speichertransistors. Insbesondere verändert sich die Einsatzspannung (Threshold-Spannung), was in bekannter Weise zum Programmieren eines "Bits" herangezogen werden kann.

Durch die Kontakt- und Kanalgeometrie des in Fig. 1(a) gezeigten Speichertransistors verlaufen die elektrischen Feldlinien zwischen dem höheren Kontaktbereich 20 und dem tieferen Kontaktbereich 22 zum Teil quer durch die Gateoxidschicht 26. Somit gibt es eine elektrische Feldkomponente, welche die Injektion von heißen Kanalelektronen in die Trapping-Schicht 28 unterstützt. Folglich werden bei Source-Drain-Spannungen oberhalb der Pinch-Off Spannung effizient Ladungsträger durch Ionisation in dem Kanalbereich zwischen dem tieferen Kontaktbereich 22 und dem Pinch-Off Punkt PO erzeugt, welche wiederum durch eine geeignete Gatespannung in die Trapping-Schicht 28 injiziert werden. Sämtliche hierzu notwendigen Spannungen liegen im Bereich unter 10 V. Das Auslesen erfolgt vorzugsweise in inverser Richtung.

Bei diesem vertikalen Konzept ist die Programmiereffizienz erhöht, da die Ausbeute an heißen Elektronen, welche in der Trapping-Schicht 28 eingelagert werden, größer ist (> 10⁻⁵ der Kanalelektronen). Ursächlich hierfür ist insbesondere eine Feldverdichtung durch die Mesakante sowie die notwendige 90°-Richtungsänderung der Elektronen im Kantenbereich. Hierdurch läßt sich die Programmierzeit und/oder die Programmierspannung bzw. -leistung deutlich reduzieren, was insbesondere für Halbleiterspeicher im mobilen Einsatzbereich wünschenswert ist.

**Fig. 1(b)** zeigt eine zweite Ausführungsform einer Speicherzelle eines erfindungsgemäßen Halbleiterspeichers. Bereits im Zusammenhang mit Fig. 1(a) beschriebene Merkmale traten gleiche Bezugszeichen und werden nicht erneut beschrieben. Die in Fig. 1(b) gezeigte Ausführungsform unterscheidet sich von der zuvor beschriebenen durch eine "Doppelstufe" bzw. doppelte Mesakante zwischen der höheren Bereichsoberfläche 16 und der tieferen Bereichsoberfläche 14. So grenzt die tiefere Bereichsoberfläche 14 an eine tiefere Stufenseitenfläche 18t an, welche mit einer höheren Stufenseitenlfäche 18h über eine Zwischenfläche 34 verbunden ist. Die Stufenseitenflächen 18t, 18h sind senkrecht zu der Substratebene angeordnet, während die Zwischenfläche 34 vorzugsweise parallel zu der Substratebene verläuft. In den Eck- bzw. Kantenbereichen, welche durch die tiefere Bereichsoberfläche 14 und die tiefere Stufenseitenfläche 18t sowie die Zwischenfläche 34 und die höhere Stufenseitenfläche 18h gebildet werden, sind jeweils Trapping-Schichten 28t, 28h angeordnet. Die Trapping-Schichten 28t, 28h sind durch eine Gateoxidschicht 26 von dem Kanalbereich beabstandet, welcher in der Halbleiterschicht p-well angeordnet ist.

Jedem Kanalbereich sind bei der in Fig. 1(b) dargestellten Ausführungsform zwei Trapping-Schichten 28t, 28h zugeordnet, so daß jeder Speichertransistor zwei "Bit" speichern kann. Das Programmieren und Lesen erfolgt hierbei analog zu NROMs und ist ausführlich in den eingangs genannten Veröffentlichungen von Eitan et al. beschrieben. Die Gateelektrode 32 erstreckt sich über die tiefere 28t und die höhere 28h Trapping-Schicht, wobei sie zwischen den Trapping-Schichten 28t, 28h bereichsweise unmittelbar an das Gateoxid 26 angrenzt. Sowohl die Gateelektrode 32 als auch die Trapping-Schichten 28t, 28h werden vorzugsweise durch eine Spacerätzung strukturiert.

**Fig. 1(c)** zeigt im schematischen Querschnitt eine dritte Ausführungsform einer Speicherzelle eines erfindungsgemäßen Halbleiterspeichers. Die Speicherzelle ähnelt stark der anhand von Fig. 1(a) beschriebenen Ausführungsvariante. Unterschiedlich ist lediglich die Ausbildung der tieferen Kontaktbereiche 22, 24, welche sich bei der in Fig. 1(c) dargestellten Ausführungsform bis zu der Stufenseitenfläche 18 erstrecken. Simulationen haben gezeigt, daß der sich bei einer derartigen Anordnung des tieferen Kontaktbereichs 22 einstellende Feldlinienverlauf zu einer besonders effizienten Injektion von Ladungsträgern in die Trapping-Schicht 28 führt.

In **Fig. 1(d)** ist eine weitere bevorzugte Ausführungsform eines Speichertransistors dargestellt, welcher sich im besonderen Maße für einen erfindungsgemäßen Halbleiterspeicher eignet. Der in Fig. 1(d) gezeigte Speichertransistor unterscheidet sich von den vorangegangenen Ausführungsformen dadurch, daß die Trapping-Schicht 28 nicht mittels einer Spacerätzung in der Mesaflanke lokal begrenzt angeordnet ist. Stattdessen erstreckt sich die Trapping-Schicht 28 von den tieferen Kontaktbereichen 22, 24 bis zu der höheren Bereichsoberfläche 16 des höheren Halbleiterbereichs 12. Somit bedeckt ein durchgehender Trapping-Schichtstapel, bei welchem es sich vorzugsweise um einen ONO-Stack handelt, den gesamten Mesaflankenbereich und insbesondere die Stufenseitenfläche 18 vollständig. Ein derartiger Speichertransistor ist besonders einfach herzustellen, da auf einen zusätzlichen Spacerätzschritt des Schichtstapels verzichtet werden kann. Ferner gestattet die in Fig. 1(d) dargestellte Ausführungsform die Speicherung von zwei "Bit" in jedem Kanalbereich, wenn die von NROMs bekannte Programmier- und Lesetechnik verwendet wird. Diese Programmier- und Lesetechnik ist in den eingangs genannten Veröffentlichungen von B. Eitan et al. ausführlich beschrieben. Diesbezüglich wird somit auf den Offenbarungsgehalt dieser Veröffentlichungen in vollem Maße Bezug genommen, welche insoweit einen integralen Offenbarungsbestandteil der vorliegenden Anmeldung darstellen.

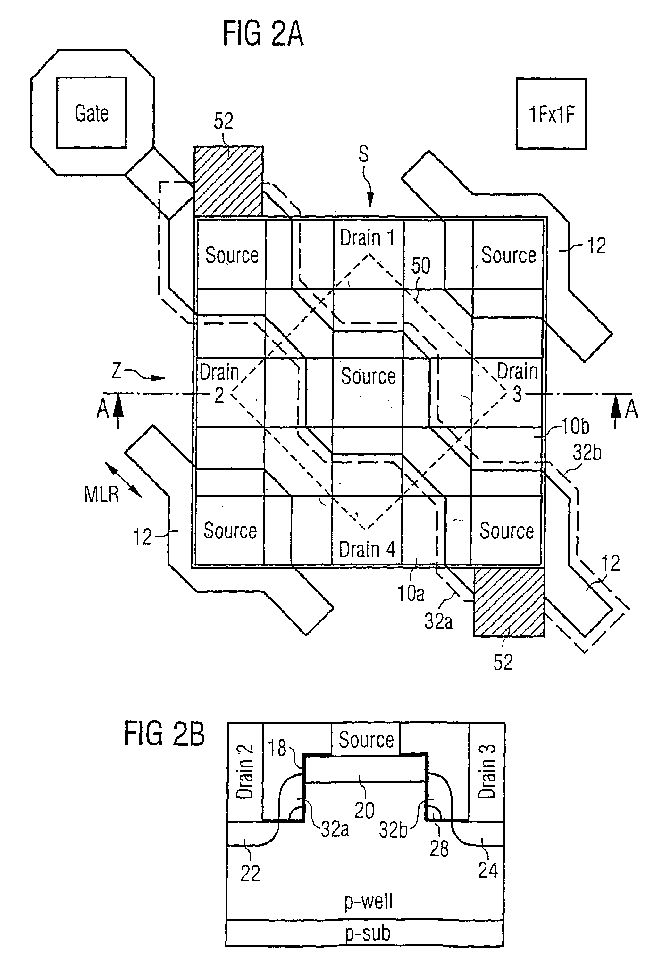

**Fig. 2(a)** zeigt eine schematische Aufsicht auf eine bevorzugte Zellenfeldanordnung eines erfindungsgemäßen Halbleiterspeichers. Die Zellenfeldanordnung ist mittels einer Überlagerung von wesentlichen Masken veranschaulicht, welche im Herstellungsprozeß Verwendung finden. Zur besseren Übersichtlichkeit ist lediglich ein sehr kleines Speicherzellenfeld gezeigt, bei welchem lediglich eine vollständige Speicherzelle dargestellt ist. Diese Speicherzelle ist durch die mit 50 bezeichnete gestrichelte Linie angedeutet und umfaßt einen höheren Kontaktbereich 20 mit einem höheren Kontakt Source. Ferner ist der Speicherzelle 50 jeweils ein Viertel von tieferen Kontaktbereichen 22, 24 mit tieferen Kontakten Drain 1, Drain 2, Drain 3, Drain 4 zugeordnet, was in der in Fig. 2(b) gezeigten Schnittansicht entlang der Linie A-A von Fig. 2(a) veranschaulicht ist. Zwischen dem höheren Kontaktbereich 20 und den jeweiligen tieferen Kontaktbereichen 22, 24 erstreckt sich jeweils ein Speichertransistorkanal an der Gateoxidschicht 26. Statt des in Fig. 2(b) im Schnitt schematisch dargestellten Speichertransistors können auch andere vertikale Speichertransistoren eingesetzt werden, insbesondere die im Zusammenhang mit Fig. 1 beschriebenen Speichertransistoren.

Die tieferen Kontakte Drain 1, Drain 2, Drain 3, Drain 4 und die höheren Kontakte Source sind in einem quadratischen, matrixartigen Raster aus Zeilen Z und Spalten S angeordnet, wobei ein Rasterelement eine Kantenlänge von F aufweist. Mit F wird hierbei die kleinste Strukturabmessung des Halbleiterspeichers bezeichnet. Entlang jeder der Zeilen Z und Spalten S des Zellenfeldes sind die tieferen Kontakte Drain 1, Drain 2, Drain 3, Drain 4 und die höheren Kontakte Source abwechselnd angeordnet, so daß jeweils ein tieferer Kontakt auf einen höheren Kontakt folgt. Die Größe einer derartigen kleinsten Zelle mit den Kantenabmessungen 1F x 1F ist in Fig. 2(a) schematisch angedeutet. Die Speicherzelle 50 weist somit einen Flächeninhalt von 8F² auf.

Wenn Speichertransistoren zum Einsatz kommen, welche pro Kanalbereich ein Bit speichern können (beispielsweise die in Fig. 1(a) und Fig. 1(c) dargestellten Speichertransistoren), so ist die 8F²-Zellen zur Speicherung von insgesamt vier Bit ausgelegt. Kommen jedoch Speichertransistoren zum Einsatz, welche pro Kanalbereich 2 Bit speichern können (beispielsweise die in Fig 1(b) und Fig. 1(d) gezeigten Speichertransistoren), so ist die 8F²-Zelle zur Speicherung von insgesamt 8 Bit ausgelegt. Pro gespeichertem "Bit" wird somit lediglich eine Fläche von 1-2F² beansprucht.

Der höhere Halbleiterbereich 12, d.h. die Mesa, erstreckt sich in einer Mesalängsrichtung MLR schräg zu der Zeilenlängsrichtung der Zeilen Z und der Spaltenlängsrichtung der Spalten S. Bei der in Fig. 2(a) gezeigten bevorzugten Anordnung beträgt der Winkel zwischen der Mesalängsrichtung MLR und den Längsrichtungen der Zeilen Z und Spalten S 45°, da ein quadratisches Raster verwendet wird. In Fig. 2(a) ist lediglich ein vollständiger höherer Halbleiterbereich 12 eines kleinen Zellenfeldes dargestellt, welchem insgesamt drei höhere Kontakte Source zugeordnet sind. Die benachbarten höheren Halbleiterbereiche 12 sind lediglich schematisch angedeutet, wobei Ihnen ein einziger höherer Kontakt Source zugeordnet ist. Der höhere Halbleiterbereich 12 trennt zwei tiefere Halbleiterbereiche 10a und 10b voneinander. Zwischen dem einen tieferen Halbleiterbereich 10a und dem höheren Halbleiterbereich 12, welcher in Fig. 2(a) in der Mitte dargestellt ist, ist eine erste Gateelektrode 32a an der Stufenseitenfläche 18 des höheren Halbleiterbereichs 12 angeordnet. In Fig. 2(a) ist die Gateelektrode 32(a) durch eine gestrichelte Linie angedeutet.

Vorzugsweise wird die Gateelektrode 32a als ein hochdotiertes Polysiliziumspacergate ausgeführt, welche ohne einen Maskenschritt (ohne Fotolithographieschritt) selbstjustierend an der Mesaflanke hergestellt werden kann. Dementsprechend ist die gestrichelte Linie in Fig. 2(a) lediglich zur Verdeutlichung der Anordnung der Gateelektrode 32a eingezeichnet und stellt keine Maske des Herstellungsprozesses dar. Durch die Spacergateelektrode 32a ist beispielsweise die Leitfähigkeit des Transistorkanals steuerbar, welcher sich zwischen dem tieferen Kontakt Drain 2 und dem höheren Kontakt Source erstreckt. Die Gateelektrode 32a wird mittels eines Gatekontakts Gate elektrisch kontaktiert, welcher in Fig. 2(a) am linken oberen Ende des Zellenfeldes angedeutet ist.

Entlang den gegenüberliegenden Stufenseitenflächen 18 des höheren Halbleiterbereichs 12 erstreckt sich eine zweite Gateelektrode 32b, welche ebenfalls ein hochdotiertes Polysiliziumspacergate ist. Das Spacergate 32b ist beispielsweise zur Steuerung der elektrischen Leitfähigkeit zwischen dem höheren Kontakt Source und dem tieferen Kontakt Drain 3 ausgelegt. Die erste Gateelektrode 32a ist von der zweiten Gateelektrode 32b mittels eines (Polysilizium-) Ätzschritts elektrisch isoliert, wobei die Ätzmaske 52 in Fig. 2(a) angedeutet ist. Der Kontaktanschluß zur Kontaktierung der Gateelektrode 32b ist in Fig. 2(a) nicht dargestellt.

Statt zwei voneinander elektrisch isolierten Gateelektroden 32a, 32b kann auch eine gemeinsame Gateelektrode 32 für beide Mesaflanken zum Einsatz kommen. In diesem Fall wird auf den zusätzlichen Spacergateätzschritt mittels der Ätzmasken 52 verzichtet. Die Gateelektroden 32a, 32b stellen die Wortleitungen des Halbleiterspeichers dar.

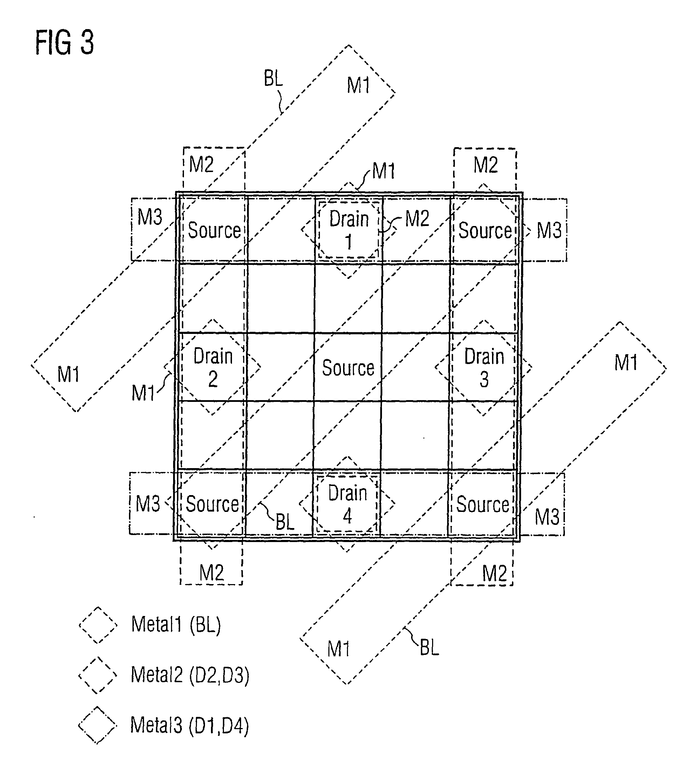

In **Fig. 3** ist eine Aufsicht auf die übereinander angeordnet dargestellten Metallisierungsmasken des Speicherzellenfeldes von Fig. 2 gezeigt. Die höheren Kontakte Source werden durch Metalleitungen BL, welche in der ersten Metallebene Metall 1 ausgebildet sind, kontaktiert. Die Metalleitungen BL stellen die Bitleitungen des Halbleiterspeichers dar. Die Richtung der Bitleitungen BL verläuft vorzugsweise senkrecht zu der Mesalängsrichtung MLR, so daß jede Bitleitung BL denselben höheren Halbleiterbereich 12 höchstens einmal kreuzt. In Fig. 3 sind drei benachbarte Bitleitungen BL in der ersten Metallebene Metall 1 angedeutet, welche parallel zueinander verlaufen. Die Bitleitungen BL zur Kontaktierung der höheren Kontakte Source sind in Fig. 3 durch eine Punktlinie dargestellt, was in der Figurenlegende verdeutlicht ist.

Die tieferen Kontakte Drain 2 und Drain 3 werden vorzugsweise über die zweite Metallebene Metall 2 kontaktiert. Hierzu sind zwei in Spaltenlängsrichtung verlaufende Leitungen M2 in der zweite Metallebene Metall 2 vorgesehen, welche in Fig. 3 durch eine gestrichelte Linie hervorgehoben sind. Die Kontaktierung der tieferen Kontakt Drain 2, Drain 3 erfolgt via die erste Metallebene Metall 1, was in Fig. 3 angedeutet ist. Die tieferen Kontakte Drain 3 und Drain 4 werden schließlich über Leitungen, welche in der dritten Metallebene Metall 3 führt sind, elektrisch kontaktiert. Diese Leitungen sind vorzugsweise senkrecht zu den in der zweiten Metallebene geführten Leitungen angeordnet und verlaufen somit entlang der Zeilenlängsrichtung. In Fig. 3 sind die in der dritten Metallebene geführten Leitungen durch eine Strich-Punkt-Linie hervorgehoben. Drain 1 und Drain 4 werden hierbei über die erste Metallebene Metall 1 (via), die zweite Metallebene Metall 2 (via) mit der dritten Metallebene Metall 3 verbunden. Somit können sämtliche tieferen Kontakte Drain 1, Drain 2, Drain 3 und Drain 4 getrennt voneinander elektrisch angesprochen werden, so daß jedes in den Speichertransistoren programmierte Bit unabhängig programmiert bzw. ausgelesen werden kann.

Wie in Fig. 3 dargestellt ist befinden sich bei dem Metallayout die Kontaktlöcher bzw. Vias der erste Metallebene Metall 1 und der zweiten Metallebene Metall 2 für die tieferen Kontakte unmittelbar übereinander und teilweise weniger als 1F-Entfernung an den Bitlines BL. Falls die Kontaktierung der tieferen Kontakte Drain 1-4 über die erste Metallebene Metall 1 beispielsweise mittels Überbelichtung oder anderer Maßnahmen problematisch ist, kann alternativ ein tiefes Kontaktloch von der zweiten Metallebene Metall 2 direkt auf die tieferen Kontaktbereiche die notwendigen elektrischen Anschlüsse herstellen.

Da die Wortleitungen (Spacergates) und Bitleitungen BL in einem Winkel von vorzugsweise 45° zu den Zeilen Z und Spalten S des Zellenfeldes ausgerichtet sind, kann es für globale Anschlüsse vorteilhaft sein, die Wort- und Bitleitungen blockweise um 90°-Biegungen hin- und herwechseln zu lassen, so daß eine sägezahnförmige (zickzack-förmige) Anordnung entsteht. Hierdurch können große Längenunterschiede zwischen den Wort- und Bitleitungen des Zellenfeldes vermieden werden, wodurch sich die Ausleseelektronik einfacher gestalten läßt.

### Bezugszeichenliste

- DRAIN 1-4: tieferer Kontakt von Speichertransistoren
- MLR: Mesalängsrichtung
- M1: Leitung in erster Metallebene Metall1
- M2: Leitung in zweiter Metallebene Metall2
- M3: Leitung in dritter Metallebene Metall3
- Metall1: erste (unterste) Metallebene
- Metall2: zweite Metallebene
- Metall3: dritte Metallebene
- p-sub: Substrat
- p-well: Halbleiterschicht
- S: Spalte
- SOURCE: höherer Kontakt von Speichertransistoren
- Z: Zeile

- 10: tieferer Halbleiterbereich
- 10a, 10b: tiefere Halbleiterbereiche auf gegenüberliegenden Seiten eines höheren Halbleiterbreichs 12
- 12: höherer Halbleiterbereich
- 14: tiefere Bereichsoberfläche
- 16: höhere Bereichsoberfläche
- 18: Stufenseitenfläche
- 20: höherer Kontaktbereich (Sourcekontakt des Speichertransistors)
- 22: tieferer Kontaktbereich (Drainkontakt des Speichertransistors)
- 24: tieferer Kontaktbereich (Drainkontakt des Speichertransistors)
- 26: Gateoxidschicht
- 28: Trapping-Schicht
- 28t: tiefere Trapping-Schicht
- 28h: höhere Trapping-Schicht
- 30: Steueroxidschicht
- 32: Gateelektrode
- 32a: erste dem tieferen Halbleiterbereich 10a zugeordnete Gateelektrode
- 32b: zweite dem tieferen Halbleiterbereich 10b zugeordnete Gateelektrode
- 34: Zwischenfläche
- 50: Speicherzelle
- 52: Ätzmaske für Polysilizium-Spacergateätzschritt

## Patentansprüche

1. Halbleiterspeicher mit einer Vielzahl von Speicherzellen, wobei jede der Speicherzellen umfaßt:
- eine auf einem Substrat (p-sub) angeordnete Halbleiterschicht (p-well), deren Halbleiteroberfläche zumindest eine Stufe zwischen einem tieferen (10) und einem in Substratnormalenrichtung höheren (12) Halbleiterbereich aufweist;
- vier in dem tieferen Halbleiterbereich (10) ausgebildete leitfähig dotierte tiefere Kontaktbereiche (22, 24) und einen in dem höheren Halbleiterbereich (12) ausgebildeten leitfähig dotierten höheren Kontaktbereich (20), wobei jeder der tieferen Kontaktbereiche (22, 24) mit genau einem angrenzendem tieferen Kontakt (DRAIN1, DRAIN2, DRAIN3, DRAIN4) und jeder der höheren Kontaktbereiche (20) mit genau einem angrenzendem höheren Kontakt (SOURCE) elektrisch verbunden ist;
- vier Kanalbereiche, welche sich in der Halbleiterschicht (p-well) zwischen den tieferen Kontaktbereichen (22, 24) und dem höheren Kontaktbereich (20) erstrecken;
- zumindest eine zum Einfangen und Abgeben von Ladungsträgern ausgelegte elektrisch isolierende Trapping-Schicht (28), welche an einer an die Kanalbereiche angrenzenden Gateoxidschicht (26) angeordnet ist; und
- zumindest eine Gateelektrode (32) zur Steuerung der elektrischen Leitfähigkeit des Kanalbereichs, wobei zwischen der Gateelektrode (32) und der Trapping-Schicht eine Steueroxidschicht (34) angeordnet ist,
wobei die tieferen (DRAIN1, DRAIN2, DRAIN3, DRAIN4) und die höheren (SOURCE) Kontakte in einem regelmäßigen matrixartigen Zellenfeld mit Zeilen (Z) und Spalten (S) angeordnet sind und entlang jeder der Zeilen (Z) und Spalten (S) die tieferen (DRAIN1, DRAIN2, DRAIN3, DRAIN4) und die höheren (SOURCE) Kontakte alternierend angeordnet sind.

2. Halbleiterspeicher nach Anspruch 1, wobei die Zeilenlängsrichtung der Zeilen (Z) und die Spaltenlängsrichtung der Spalten (S) senkrecht zueinander verlaufen.

3. Halbleiterspeicher nach einem der vorangegangenen Ansprüche, wobei jeder der höheren Halbleiterbereiche (12) eine Vielzahl der höheren Kontaktbereiche (20) aufweist.

4. Halbleiterspeicher nach Anspruch 3, wobei sich die höheren Halbleiterbereiche (12) in schräg zu der Zeilen- und der Spaltenlängsrichtung verlaufenden Mesalängsrichtungen (MLR) erstrecken.

5. Halbleiterspeicher nach Anspruch 4, wobei jeder der höheren Halbleiterbereiche (12) zwei der tieferen Halbleiterbereiche (10; 10a, 10b) voneinander trennt, welche an gegenüberliegenden Stufenseitenflächen (18) des höheren Halbleiterbereichs (12) angrenzen.

6. Halbleiterspeicher nach einem der vorangegangenen Ansprüche, wobei jedem der höheren Halbleiterbereiche (12) eine gemeinsame Gateelektrode (32) zugeordnet ist.

7. Halbleiterspeicher nach einem der Ansprüche 1 bis 5, wobei jedem der höheren Halbleiterbereiche (12) zwei elektrisch voneinander isolierte Gateelektroden (32a, 32b) zugeordnet sind.

8. Halbeiterspeicher nach einem der Ansprüche 6 oder 7, wobei sich die Gateelektrode(n) (32; 32a, 32b) im wesentlichen entlang der Mesalängsrichtung (MLR) des höheren Halbleiterbereichs (12) angrenzend an dessen Stufenseitenflächen (18) erstreckt bzw. erstrecken.

9. Halbleiterspeicher nach einem der vorangegangenen Ansprüche und Anspruch 5, wobei eine Vielzahl von senkrecht zu den Mesalängsrichtungen (MLR) verlaufenden Bitleitungen (BL) vorgesehen ist, welche jeweils mit einer Vielzahl der höheren Kontakte (SOURCE) elektrisch verbunden sind.

10. Halbleiterspeicher nach einem der vorangegangenen Ansprüche, wobei Bereichsoberflächen (14, 16) des tieferen (10) und des höheren (12) Halbleiterbereichs im wesentliche parallel zu der Substratebene (p-sub) verlaufen.

11. Halbleiterspeicher nach einem der vorangegangenen Ansprüche, wobei die Bereichsoberflächen (14, 16) des tieferen (10) und des höheren (12) Halbleiterbereichs durch eine Stufenseitenfläche (18) der Stufe verbunden sind, welche im wesentlichen senkrecht zu der Substratebene (p-sub) verläuft.

12. Halbleiterspeicher einem der vorangegangenen Ansprüche, wobei die Trapping-Schicht (28) durch die Gateoxidschicht (26) von der Stufenseitenfläche (18) und der Bereichsoberfläche (14) des tieferen Halbleiterbereichs (10) beabstandet ist.

13. Halbleiterspeicher nach einem der Ansprüche 1 bis 10, wobei die Bereichsoberflächen (14, 16) des tieferen (10) und des höheren (12) Halbleiterbereichs durch eine tiefere Stufenseitenfläche (18t), eine höhere Stufenseitenfläche (18h) und eine sich zwischen den Stufenseitenflächen (18t, 18h) erstreckende Zwischenfläche (34) miteinander verbunden sind.

14. Halbleiterspeicher nach Anspruch 13, wobei jedem der Kanalbereiche eine tiefere (28t) und eine höherere (28h) der Trapping-Schichten (28) zugeordnet ist, wobei die tiefere Trapping-Schicht (28t) durch die Gateoxidschicht (26) von der tieferen Stufenseitenfläche (18t) und der Bereichsoberfläche (14) des tieferen Halbleiterbereichs (10) und die höhere Trapping-Schicht (18h) durch die Gateoxidschicht (26) von der höheren Stufenseitenfläche (18h) und der Zwischenfläche (34) beabstandet ist.

15. Halbleiterspeicher nach einem der vorangegangenen Ansprüche, wobei sich der tiefere Kontaktbereich (22) bis an eine Stufenseitenfläche (18) der Stufe erstreckt..

## Claims

1. Semiconductor memory having a multiplicity of memory cells, each of the memory cells comprising:
- a semiconductor layer (p-well) arranged on a substrate (p-sub), the semiconductor surface of said semiconductor layer having at least one step between a deeper semiconductor region (10) and a semiconductor region (12) that is higher in the direction of the normal to the substrate;
- four conductively doped deeper contact regions (22, 24) formed in the deeper semiconductor region (10), and a conductively doped higher contact region (20) formed in the higher semiconductor region (12), each of the deeper contact regions (22, 24) being electrically connected to precisely one adjoining deeper contact (DRAIN1, DRAIN2, DRAIN3, DRAIN4) and each of the higher contact regions (20) being electrically connected to precisely one adjoining higher contact (SOURCE);
- four channel regions extending in the semiconductor layer (p-well) between the deeper contact regions (22, 24) and the higher contact region (20);
- at least one electrically insulating trapping layer (28) designed for trapping and emitting charge carriers, which layer is arranged on a gate oxide layer (26) adjoining the channel regions; and
- at least one gate electrode (32) for controlling the electrical conductivity of the channel region, a control oxide layer (34) being arranged between the gate electrode (32) and the trapping layer,
the deeper contacts (DRAIN1, DRAIN2, DRAIN3, DRAIN4) and the higher contacts (SOURCE) being arranged in a regular matrix-like cell array with rows (Z) and columns (S) and the deeper contacts (DRAIN1, DRAIN2, DRAIN3, DRAIN4) and the higher contacts (SOURCE) being arranged alternately along each of the rows (Z) and columns (S).

2. Semiconductor memory according to Claim 1, the row longitudinal direction of the rows (Z) and the column longitudinal direction of the columns (S) running perpendicular to one another.

3. Semiconductor memory according to one of the preceding claims, each of the higher semiconductor regions (12) having a multiplicity of the higher contact regions (20).

4. Semiconductor memory according to Claim 3, the higher semiconductor regions (12) extending in mesa longitudinal directions (MLR) running obliquely with respect to the row and column longitudinal directions.

5. Semiconductor memory according to Claim 4, each of the higher semiconductor regions (12) separating two of the deeper semiconductor regions (10; 10a, 10b) from one another which adjoin opposite step side areas (18) of the higher semiconductor region (12).

6. Semiconductor memory according to one of the preceding claims, each of the higher semiconductor regions (12) being assigned a common gate electrode (32).

7. Semiconductor memory according to one of Claims 1 to 5, each of the higher semiconductor regions (12) being assigned two gate electrodes (32a, 32b) that are electrically insulated from one another.

8. Semiconductor memory according to either of Claims 6 and 7, the gate electrode(s) (32; 32a, 32b) extending essentially along the mesa longitudinal direction (MLR) of the higher semiconductor region (12) in a manner adjoining the step side areas (18) thereof.

9. Semiconductor memory according to one of the preceding claims and Claim 5, a multiplicity of bit lines (BL) running perpendicular to the mesa longitudinal directions (MLR) being provided, which bit lines are in each case electrically connected to a multiplicity of the higher contacts (SOURCE).

10. Semiconductor memory according to one of the preceding claims, region surfaces (14, 16) of the deeper (10) and of the higher (12) semiconductor region running essentially parallel to the substrate plane (p-sub).

11. Semiconductor memory according to one of the preceding claims, the region surfaces (14, 16) of the deeper (10) and of the higher (12) semiconductor region being connected by a step side area (18) of the step, which runs essentially perpendicular to the substrate plane (p-sub).

12. Semiconductor memory according to one of the preceding claims, the trapping layer (28) being spaced apart from the step side area (18) and the region surface (14) of the deeper semiconductor region (10) by the gate oxide layer (26).

13. Semiconductor memory according to one of Claims 1 to 10, the region surfaces (14, 16) of the deeper (10) and of the higher (12) semiconductor region being connected to one another by a deeper step side area (18t), a higher step side area (18h) and an intermediate area (34) extending between the step side areas (18t, 18h).

14. Semiconductor memory according to Claim 13, each of the channel regions being assigned a deeper (28t) and a higher (28h) one of the trapping layers (28), the deeper trapping layer (28t) being spaced apart from the deeper step side area (18t) and the region surface (14) of the deeper semiconductor region (10) by the gate oxide layer (26) and the higher trapping layer (18h) being spaced apart from the higher step side area (18h) and the intermediate area (34) by the gate oxide layer (26).

15. Semiconductor memory according to one of the preceding claims, the deeper contact region (22) extending as far as a step side area (18) of the step.

## Revendications

1. Mémoire à semi-conducteur qui présente plusieurs cellules de mémoire, chacune des cellules de mémoire comprenant :
- une couche de semi-conducteur (p-well) disposée sur un substrat (p-sub) et dont la surface semi-conductrice présente au moins un gradin entre une partie de semi-conducteur plus profonde (10) et une partie de semi-conducteur plus élevée (12) dans la direction perpendiculaire au substrat,
- quatre zones de contact plus profondes (22, 24) dopées de manière à être conductrices et formées dans la partie semi-conductrice plus profonde (10) et une zone de contact (20) plus élevée, dopée de manière à être conductrice, formée dans la partie semi-conductrice plus élevée (12), chacune des zones de contact plus profondes (22, 24) étant reliée électriquement à exactement un contact plus profond adjacent (DRAIN1, DRAIN2, DRAIN3, DRAIN4) et chacune des zones de contact plus élevées (20) a exactement un contact plus élevé adjacent (SOURCE),
- quatre zones de canal qui s'étendent dans la couche semi-conductrice (p-well) entre les zones de contact plus profondes (22, 24) et la zone de contact plus élevée (20),
- au moins une couche de piégeage (28) électriquement isolante conçue pour recevoir et émettre des porteurs de charge et disposée sur une couche (26) d'oxyde de grille adjacente aux zones de canal et
- au moins une électrode de grille (32) qui commande la conductivité électrique de la zone de canal, une couche d'oxyde de commande (34) étant disposée entre l'électrode de grille (32) et la couche de piégeage,
- les contacts plus profonds (DRAIN1, DRAIN2, DRAIN3, DRAIN4) et les contacts plus élevés (SOURCE) étant disposés en champ régulier de cellules en forme de matrice qui présente des lignes (Z) et des colonnes (S), les contacts plus profonds (DRAIN1, DRAIN2, DRAIN3, DRAIN4) et les contacts plus élevés (SOURCE) étant disposés le long de chacune des lignes (Z) et de chacune des colonnes (S).

2. Mémoire à semi-conducteur selon la revendication 1, dans laquelle le sens de la longueur des lignes (Z) et le sens de la longueur des colonnes (S) s'étendent perpendiculairement l'un à l'autre.

3. Mémoire à semi-conducteur selon l'une des revendications précédentes, dans laquelle chacune des zones semi-conductrices plus élevées (12) présente plusieurs zones de contact plus élevées (20).

4. Mémoire à semi-conducteur selon la revendication 3, dans laquelle les zones semi-conductrices plus élevées (12) s'étendent dans des directions longitudinales en "mesa" (MLR) qui s'étendent obliquement par rapport à la direction des lignes et à la direction des colonnes.

5. Mémoire à semi-conducteur selon la revendication 4, dans laquelle chacune des zones semi-conductrices plus élevées (12) sépare l'une de l'autre deux des zones semi-conductrices plus profondes (10; 10a, 10b) adjacentes aux surfaces latérales opposées (18) en gradin de la zone semi-conductrice plus élevée (12).

6. Mémoire à semi-conducteur selon l'une des revendications précédentes, dans laquelle une électrode de grille commune (32) est associée à chacune des zones semi-conductrices plus élevées (12).

7. Mémoire à semi-conducteur selon l'une des revendications 1 à 5, dans laquelle deux électrodes de grille (32a, 32b) isolées électriquement l'une de l'autre sont associés à chacune des zones semi-conductrices plus élevées (12).

8. Mémoire à semi-conducteur selon l'une des revendications 6 ou 7, dans laquelle la ou les électrodes de grille (32; 32a, 32b) s'étendent essentiellement dans le sens de la longueur des "mesas" (MLR) de la zone semi-conductrice plus élevée (12) en position adjacente à leurs surfaces latérales (18) en gradin.

9. Mémoire à semi-conducteur selon l'une des revendications précédentes et la revendication 5, dans laquelle plusieurs conducteurs de bits (BL) qui s'étendent perpendiculairement au sens de la longueur des "mesas" (MLR) sont prévus et sont reliés électriquement chacun à plusieurs des contacts plus élevés (SOURCE).

10. Mémoire à semi-conducteur selon l'une des revendications précédentes, dans laquelle les surfaces (14, 16) de la zone semi-conductrice plus profonde (10) et de la zone semi-conductrice plus élevée (12) s'étendent essentiellement en parallèle au plan du substrat (p-sub).

11. Mémoire à semi-conducteur selon l'une des revendications précédentes, dans laquelle les surfaces (14, 16) de la partie semi-conductrice plus profonde (10) et de la partie semi-conductrice plus élevée (12) sont reliées par une surface latérale (18) du gradin qui s'étend essentiellement à la perpendiculaire du plan du substrat (p-sub).

12. Mémoire à semi-conducteur selon l'une des revendications précédentes, dans laquelle la couche de piégeage (28) est maintenue à distance de la surface latérale (18) du gradin et de la surface (14) de la partie semi-conductrice plus profonde (10) par la couche (26) d'oxyde de grille.

13. Mémoire à semi-conducteur selon l'une des revendications 1 à 10, dans laquelle les surfaces (14, 16) de la partie semi-conductrice plus profonde (10) et de la partie semi-conductrice plus élevée (12) sont reliées l'une à l'autre par une surface latérale plus profonde (18t) en gradin, une surface latérale plus élevée (18h) en gradin et une surface intermédiaire (34) qui s'étend entre les surfaces latérales (18t, 18h) en gradin.

14. Mémoire à semi-conducteur selon la revendication 13, dans laquelle une couche de piégeage plus profonde (28t) et une couche de piégeage plus élevée (28h) des couches de piégeage (28) sont associées aux parties de canal, la couche de piégeage plus profonde (28t) étant maintenue à distance de la surface latérale (18t) en gradin par la couche d'oxyde de grille (26) et la surface (14) de la partie semi-conductrice plus profonde (10) ainsi que la couche de piégeage plus élevée (18h) sont maintenues à distance de la surface latérale plus élevée (18h) en gradin et la surface intermédiaire (34) par la couche (26) d'oxyde de grille.

15. Mémoire à semi-conducteur selon l'une des revendications précédentes, dans laquelle la zone de contact plus profonde (22) s'étend jusqu'à la surface latérale (18) en gradin.
